# EUROPÄISCHE PATENTSCHRIFT

(11) **EP 0 667 877 B1**
(45) Veröffentlichungstag und Bekanntmachung des Hinweises auf die Patenterteilung: **14.01.1998**
(21) Anmeldenummer: 93924006.5
(22) Anmeldetag: 27.10.1993
(51) Int. Cl.: C08G 59/30, C08G 59/22, C08G 59/38, G03F 7/038, H01B 3/40

(54) **EINKOMPONENTIGES REAKTIONSHARZSYSTEM**
UNITARY REACTION RESIN SYSTEMS
SYSTEME UNITAIRE DE RESINE COMPOSITE

(30) Priorität: 03.11.1992 DE 4237132
(43) Veröffentlichungstag der Anmeldung: 23.08.1995
(73) Patentinhaber: SIEMENS AKTIENGESELLSCHAFT, 80333 München (DE)
(72) Erfinder: BAYER, Heiner, D-82140 Olching (DE); PLUNDRICH, Winfried, D-82110 Germering (DE); WIPFELDER, Ernst, D-81673 München (DE)
(86) Internationale Anmeldenummer: DE9301024
(87) Internationale Veröffentlichungsnummer: WO9410223

(56) Entgegenhaltungen:
- EP-A- 0 033 295
- EP-A- 0 408 990
- EP-A- 0 412 425
- US-A- 2 856 368
- DATABASE WPI Week 8616, Derwent Publications Ltd., London, GB; AN 86-102699 & JP,A,61 046 054 (TOYOBO) 6. März 1986

## Beschreibung

Für die Abdeckung und Umhüllung elektronischer Bauelemente werden verarbeitungssichere flammwidrige Reaktionsharzformstoffe benötigt. Insbesondere bei passiven Bauelementen ist dabei als Applikationsform die Gießtechnologie gebräuchlich. Darüber hinaus wird auch der Reaktionsspritzguß angewendet.

In der Regel werden Harz- und Härterkomponenten getrennt voneinander gelagert und gehandhabt und erst unmittelbar vor der Applikation vereinigt und zur gebrauchsfertigen Reaktionsharzmasse aufbereitet. Die dafür erforderlichen Verarbeitungsanlagen sind kosten- und wartungsintensiv, da die gebrauchsfertige Reaktionsharzmasse relativ schnell aushärtet und so in regelmaßigen Abständen aus den Verarbeitungsanlagen entfernt werden muß.

Vorteile bei der Verarbeitung werden mit Einkomponenten-Reaktionsharzen erzielt, die wegen der entfallenden Vormischung der Komponenten eine höhere Verfahrenssicherheit und damit eine reproduzierbare Qualität gewährleisten, sofern die einkomponentigen Harze bei Raumtemperatur mindestens drei Monate lagerfähig sind und sofern die Härtungsbedingungen gemaßigt sind bzw. mit dem zu vergießenden Bauelement verträglich sind.

Gebräuchliche einkomponentige Reaktionsharze basieren auf Epoxidharzen und Dicyandiamid. Sie werden in der Regel als Kunststoffe eingesetzt. Für Gießharzanwendungen sind derartige Systeme aufgrund der Unverträglichkeit von Dicyandiamid in Epoxidharzen und der erforderlichen Härungstemperaturen (>150°) nicht geeignet.

Aus der EP-0 408 990 A3 ist ein thermisch härtendes Reaktionsharzsystem bekannt, welches ein polyfunktionelles Epoxid, eine epoxidgruppenhaltige Phosphorverbindung, ein polyfunktionelles Isocyanat und einen Härtungskatalysator umfaßt, und aus dem schwer brennbare Formstoffe herstellbar sind.

Eine weitere Möglichkeit, zu niedrigeren Härtungstemperaturen zu kommen, ist die Lagerung von an sich reaktiven Systemen bei reduzierter Temperatur. Verarbeitungsfertige und komplett aufbereitete Reaktionsharze werden zum Beispiel bei minus 25° ge-kühlt und sind bei dieser Temperatur bis zu sechs Monaten lagerfähig. So entsteht jedoch erheblicher Aufwand für Transport und Lagerhaltung. Vor Gebrauch müssen diese Produkte unter Feuchtigkeitsausschluß auf Verarbeitungstemperatur aufgewärmt werden.

Strahlenhärtbare Reaktionsharze sind in der Regel lagerstabil. Sie eignen sich jedoch nur für Anwendungen in dünnen Schichten, die nicht gegenüber der Bestrahlung abgeschattet sein dürfen.

Eine weitere Alternative stellen einkomponentige Reaktionsharze dar, die kationisch katalysiert thermisch aushärten. Die katalytische Aktivierung erfolgt durch Bestrahlung, wobei ein geeigneter Photoinitiator in Kationen zerfällt. Die weitere Aushärtung erfolgt katalytisch, und wird durch Temperaturerhöhung beschleunigt.

Die UV-Aktivierung solcher Systeme kann dabei nach dem Aufbringen, beispielsweise auf einem Substrat erfolgen, wie es etwa aus der EP 0 094 915 A bekannt ist. Auf diese Weise ent steht jedoch kein wochenlang lagerstabiles flüssiges Reaktionsharz.

In der US 4 880 662 wird eine Vorrichtung vorgeschlagen, geeignete UV-aktivierbare einkomponentige Systeme vor dem Aufbringen durch Bestrahlung zu aktivieren, so daß die Reaktionsharze auch für abgeschattete Bauelemente und insbesondere für den Verguß von Bauteilen geeignet sind.

Aufgabe der vorliegenden Erfindung ist es, solche Einkomponentensysteme bereitzustellen und insbesondere den Flammschutz zu verbessern.

Diese Aufgabe wird erfindungsgemäß gelöst durch ein einkomponentiges Reaktionsharzsystem nach Anspruch 1.

Weitere Ausgestaltungen der Erfindung sowie erfindungsgemäße Verwendungen sind den Unteransprüchen zu entnehmen.

Überraschend wurde gefunden, daß Mischungen aus handelsüblichen Epoxidkomponenten und Glycidylestern von Phosphonsäure, Phosphinsäure und Phosphorsäure, versetzt mit gebräuchlichen kationischen Photoinitiatoren niederviskose Reaktionsharzmassen ergeben, die rein thermisch nicht härtbar sind. Dies ist insofern überraschend, als Phosphorverbindungen, zum Beispiel Phosphine und Phosphoniumsalze in verschiedenen Harzsystemen bislang als Beschleuniger eingesetzt werden. Das erfindungsgemäße Reaktionsharzsystem kann jedoch bei Temperaturen bis 150°C behandelt werden, ohne daß eine Härtungsreaktion einsetzt.

Doch auch nach Aktivierung des Reaktionsharzsystems mit UV-Licht bleibt dieses bei Raumtemperatur über mehrere Monate flüssig. Dies ermöglicht ein problemloses Arbeiten, in einer Anlage. Die mit dem aktivierten Reaktionsharzsystem in direkten Kontakt kommenden Applikationsvorrichtungen oder auch nur Vorrats- und Transportbehälter können also eine entsprechend lange Zeit ohne erforderliche Zwischenreinigung in Betrieb bleiben, da während dieser Zeit eine Aushärtung in der Vorrichtung nicht zu befürchten ist.

Andererseits ist das erfindungsgemäße Reaktionsharzsystem bereits bei mäßigen Temperaturen aushärtbar. Es findet also eine rasche thermische Härtung statt, beispielsweise innerhalb weniger als einer Stunde bei 100 bis 150°C. Bei niedrigen Temperaturen sind natürlich entsprechend längere Härtungszeiten erforderlich.

Das Reaktionsharzsystem ist daher besonders für die Gießtechnologie geeignet. Aufgrund der relativ geringen Härtungstemperaturen und der vor dem Aufbringen möglichen Aktivierung des Reaktionsharzsystems kann es auch in dicken Schichten aufgebracht werden, die spannungsarm und vollständig durchgehärtet werden können.

Die niedrig einstellbare Viskosität des Reaktionsharzsystems erlaubt es außerdem, einen hohen Anteil Füllstoff zuzusetzen und trotzdem noch eine gute Verarbeitbarkeit zu erhalten.

Die reaktive Phosphorkomponente wird beim Aushärten in den Reaktionsharzformstoff eingebaut und zeigt daher auch bei Temperaturbelastung des Reaktionsharzformstoffes keine Migration. Die durch den Phosphorzusatz bedingten flammwidrigen Eigenschaften des Formstoffes bleiben daher erhalten.

Zwar ist es bekannt, daß der Zusatz von phosphorhaltigen Verbindungen zu Kunststoffen wie beispielsweise Reaktionsharzen zu einem flammwiderigen Verhalten führt, jedoch zeigte sich, daß erfindungsgemäße phosphorhaltige Verbindungen die katalytische Härtung von Reaktionsharzsystemen beeinträchtigen. Selbst mit zugesetztem zusätzlichem Beschleuniger wie Imidazolen härten die Harze nur langsam und nicht vollständig aus, was zu schlechten Formstoff-Eigenschaften führt. Es erwies sich für phosphorhaltige Reaktionsharzsysteme äußerst schwierig, überhaupt Beschleuniger zu finden. Die im erfindungsgemäßen Reaktionsharzsystem enthaltenen Phosphorverbindungen führen also dazu, daß sich das System ohne Photoinitiator nicht, mit Photoinitiator dagegen schnell und vollständig aushärten läßt. Ein zusätzlicher Beschleuniger ist nicht erforderlich.

Als Epoxidharz (Bestandteil A) kann ein handelsübliches Epoxidharz oder ein Gemisch aus handelsüblichen Epoxidharzen ausgewählt werden. Bevorzugt sind aromatische Glycidylether, beispielsweise auf der Basis von Bisphenolen oder von Novolaken. Auch cycloaliphatische Epoxide sind geeignet. Der Anteil des Bestandteils A am gesamten System beträgt ca. 30 bis 90 Gewichtsprozent.

Im erfindungsgemäßen Reaktionsharzsystem ist der Photoinitiator (Bestandteil B) in einem Anteil von ca. 0,1 bis 5 Gewichtsprozent enthalten. Geeignete Protonen freisetzende Photoinitiatoren für den UV-initiierten kationischen Härtungsmechanismus sind beispielsweise von stabilen organischen Oniumsalzen abgeleitet, insbesondere mit Stickstoff, Phosphor , Sauerstoff, Schwefel, Selen oder Jod als Zentralatom des Kations. Als besonders vorteilhaft haben sich aromatische Sulfonium- und Jodoniumsalze mit komplexen Anionen erwiesen. Auch ein eine Lewis-Säure freisetzender und beispielsweise als pi-Donor-Übergangsmetallkomplex realisierter Photoinitiator ist möglich. Weiterhin zu nennen sind Phenacylsulfoniumsalze, Hydroxylphenylsulfoniumsalze sowie Sulfoxoniumsalze. Einsetzbar sind desweiteren Oniumsalze, die nicht direkt, sondern über einen Sensibilisator zur Säurebildung angeregt werden. Auch organische Siliziumverbindungen, die bei UV-Bestrahlung in Anwesenheit von aluminiumorganischen Verbindungen ein Silanol freisetzen, können die Härtung des erfindungsgemaßen Systems initiieren.

Für den Bestandteil C eignen sich epoxidgruppenhaltige phosphororganische Verbindungen. Phosphorhaltige Di- und Triglycidylester sind bevorzugt. Zwei oder drei reaktive Glycidylestergruppen sorgen für eine bessere Einbindung der Komponente B in den Formstoff, so daß Stabilität und thermisch mechanische Eigenschaften des Formstoffes verbessert werden. Wird im Eigenschaftsprofil des Formstoffes der Flammschutz eingeschlossen, so ist der Phosphonsäurediglycidylester mit einem aromatischen Rest R bevorzugt.

Der Phosphorgenalt des (ungefüllten) Reaktionsharzsystems wird auf ca. 1 bis 5 Gewichtsprozent eingestellt. Bei Betonung der Flammschutzwirkung wird ein möglichst hoher Phosphorgehalt gewählt, der jedoch gegen die mit dem Phosphorgehalt anwachsende Hydrolyseempfindlichkeit abzuwägen ist. Ein geringerer Phosphorgehalt führt zu einer geringeren Gebrauchsdauer, da erfindungsgemäß die Phosphorverbindung die Lagerstabilität erhöht. Bevorzugt sind daher ca. 2 bis 4 Gewichtsprozent Phosphorgehalt. Der optimale Phosphorgehalt bezüglich Lagerstabilität richtet sich auch nach der Photoinitiatorkonzentration und der Bestrahlungszeit.

Zur Einstellung der Formstoffeigenschaften können im Reaktonsharzsystem neben der Epoxidkomponente noch weitere mit dieser zusammen polymerisierbare Verbindungen zugesetzt werden. Besonders geeignet sind dazu cyclische Ether und cyclische Ester. Auch Vinylether und niedermolekulare Polyhydroxylverbindungen wie Polyetherpolyole und Polyesterpolyole sind geeignet.

Weiterhin können im Reaktionsharzsystem für Gießharze übliche Zusätze enthalten sein, beispielsweise Haftvermittler, Verlaufshilfsmittel, Farbstoffe, Thixotropierungsmittel und insbesondere Füllstoffe. Zusätze, die die Aktivierung beeinträchtigen, können auch noch nach derselben zugefügt werden. Zur Erniedrigung der Viskosität eines mit Füllstoff vermischten Reaktionsharzsystems ist beispielsweise eine erhöhte Verarbeitungstemperatur von ca. 60 bis 80° C möglich.

Das erfindungsgemäße Reaktionsharzsystem ist nicht UV-härtend, sondern nur UV-aktiviert thermisch härtend. Das nicht aktivierte Reaktionsharzsystem ist thermisch vollkommen inert und zeigt auch nach einer Behandlung bei hohen Temperaturen (zum Beispiel lh/150°C) einen nur unwesentlichen Viskositätsanstieg. Nach der UV-Aktivierung bleibt das Reaktionsharzsystem für mehrere Monate lagerstabil, ohne seine Gebrauchsfähigkeit einzubüßen. Zur Applikation ist es möglich, die Temperatur auf 60 bis 80°C zu erhöhen. Dennoch erfolgt die Härtung bei gemäßigten Temperaturen (zum Beispiel 100 bis 150°C) in relativ kurzer Zeit (innerhalb 1 Stunde) vollständig. Diese Härtungsbedingungen sind mit denen zweikomponentiger aus Harz und Härter bestehender Reaktionsharzsysteme vergleichbar, weisen diesen gegenüber jedoch den Vorteil des gebrauchsfertig lagerstabilen Einkomponentensystems auf und erfordern kein Zusammenmischen von Harz und Härter unmittelbar vor der Applikation.

Die UV-Aktivierung kann sowohl vor als auch nach der Applikation, im ersteren Fall in oder außerhalb der Applikationsvorrichtung durch kontinuierliche oder diskontinuierliche Bestrahlung mit einer geeigneten Lichtquelle durchgeführt werden. Die zur Aktivierung erforderlich Wellenlänge ist vom ausgewählten Photoinitiator abhängig.

Geeignete Vorrichtungen, die eine kontinuierliche Aktivierung während der Applikation ermöglichen, können aus der US 4 880 662 bzw. aus der EP-0 279199 A2 entnommen werden.

Im folgenden wird die Erfindung anhand von drei beispielhaft angegebenen Zusammensetzungen eines erfindungsgemäßen Reaktionsharzsystems sowie anhand von weiteren Untersuchungen und der dazu gehörigen zwei Figuren näher erläutert.

Die Figuren zeigen die anhand der Viskosität gemessene Lagerstabilität eines erfindungsgemäßen Reaktionsharzsystems in Abhängigkeit verschiedener Parameter.

### Erstes Ausführungsbeispiel

20 Masseteile Bisphenol-A-Diglycidylether (Epoxid equivalent 0,5 Mol/100 g), 7,3 Masseteile Phenylphosphonsäure Diglycidylester und 0,27 Masseteile einer 50-%igen Lösung des Photoinitiators Diphenyl-4-thiophenoxyphenylsulfonium Hexafluoroantimonat in Propylencarbonat werden homogen vermischt. Ohne Aktivierung ist diese Mischung bei Raumtemperatur über ein Jahr lagerfähig.

Zur Aktivierung wird die Mischung mit einer UV-Lampe mit einer Leistung von 50 mW/cm² für eine Minute bestrahlt. Die aktivierte Mischung ist nach über 3 monatiger Lagerung bei Raumtemperatur noch verarbeitungsfähig und kann dann innerhalb einer Stunde bei 150°C gehärtet werden. Der erhaltene Reaktionsharzformstoff zeigt eine Glasübergangstemperatur von 82°C.

### Zweites Ausführungsbeispiel

116 Masseteile eines Epoxy-Phenol-Novolak (Epoxid equivalent 0,6 Mol/100 g), 43 Masseteile Phenylphosphonsäure Digylcidylester, 3,2 Masseteile des Photoinitiators vom ersten Ausführungsbeispiel und 40 Masseteile eines Aluminiumhydroxidfüllstoffes (Apyral 4) werden bei 70°C homogen vermischt. Das mit Füllstoff versehene Reaktionsharzsystem wird schließlich einer einminütigen UV-Bestrahlung ausgesetzt.

Nach zwei Wochen Lagerung bei Raumtemperatur wird die Mischung in geeignete Gießformen gefüllt, dann bei 110°C eine Stunde und bei 150°C zwei Stunden gehärtet. So werden genormte Prüfstäbe hergestellt und deren Eigenschaften bestimmt. Der Reaktionsharzformstoff zeigt eine Glasübergangstemperatur von 124°C, gute chemische Eigenschaften wie geringe Wasseraufnahme und hohe Hydrolysestabilität und erfüllt die Flammschutzprüfung gemäß der Norm der Underwriters Laboratories UL 94 V0 bis zu einer Probendicke von 0,8 mm.

### Drittes Ausführungsbeispiel

50 Masseteile Bisphenol-A-Diglycidylether (Epoxid equivalent 0,5 Mol/100 g), 17,5 Masseteile Phenylphosphonsäure Diglycidylester, 2,0 Masseteile 2,4-Cyclopentadien-1-yl-(1-methylethyl) Benzol-Eisenhexafluorophosphat, 1,7 Masseteile Cumolhydroperoxid und 0,25 Masseteile Anthracen werden bei 60°C homogen vermischt.

zur Aktivierung wird die Reaktionsharzmischung in einer 2 mm dicken Schicht einer zweiminütigen UV-Behandlung ausgesetzt. Das aktivierte Reaktionsharzsystem bleibt auch nach sechs Wochen Lagerung bei Raumtemperatur verarbeitungsfähig. Es läßt sich nach thermischer Behandlung zu flammhemmenden festen Reaktionsharzformstoffen härten.

Zur weiteren Charakterisierung der Reaktionsharzsysteme wird das Härtungsverhalten in Abhängigkeit vom Vorhandensein verschiedener Bestandteile und vom Durchführen von Maßnahmen (UV-Belichtung, thermische Behandlung) untersucht. Die nachfolgende Tabelle stellt das Ergebnis einer Variation des ersten Ausführungsbeispiels dar. In sämtlichen Versuchen bleiben die Epoxidhauptkomponente und die phosphorhaltige Komponente unverändert. Der Phosphoranteil ist auf 3 Prozent eingestellt. Der Photoinitiator liegt - falls vorhanden - in einem Anteil von einem Gewichtsprozent vor, die UV-Belichtungszeit ist auf eine Minute, die Härtungszeit auf eine Stunde (bei 150°C) eingestellt. In einem Fall wird ein stickstoffhaltiges Epoxid zugesetzt

**Tabelle 1**

| Epoxid-zusatz N-haltig | Füllstoff (Apyral4) | Photo-in-itiator | UV-Bel. | therm. Behandl. | Härtungs-ergebnis |
|---|---|---|---|---|---|
| - | - | x | x | - | flüssig |
| - | - | x | x | x | fest |
| - | x | x | x | x | fest |
| x | - | x | x | x | flüssig |
| - | - | x | - | x | flüssig |
| - | - | - | x | x | flüssig |
| - | - | - | - | X | flüssig |

Wie aus den Versuchsergebnissen klar hervorgeht, ist für den Härtungsprozeß der Photoinitiator unerläßlich. Auch ohne UV-Aktivierung oder ohne thermische Behandlung bleibt das Reaktionsharzsystem flüssig. Der Härtungsprozeß wird nicht durch die Zugabe von Füllstoff beeinträchtigt. Kein erfindungsgemäßes Härtungsergebnis wird dagegen erzielt, wenn stickstoffhaltige Verbindungen im Reaktionsharzsystem enthalten sind, beispielsweise N-haltige Epoxide oder N-haltige Beschleuniger. Klar wird auch, daß durch eine thermische Behandlung ohne Photoinitiator keine Hartung erfolgt.

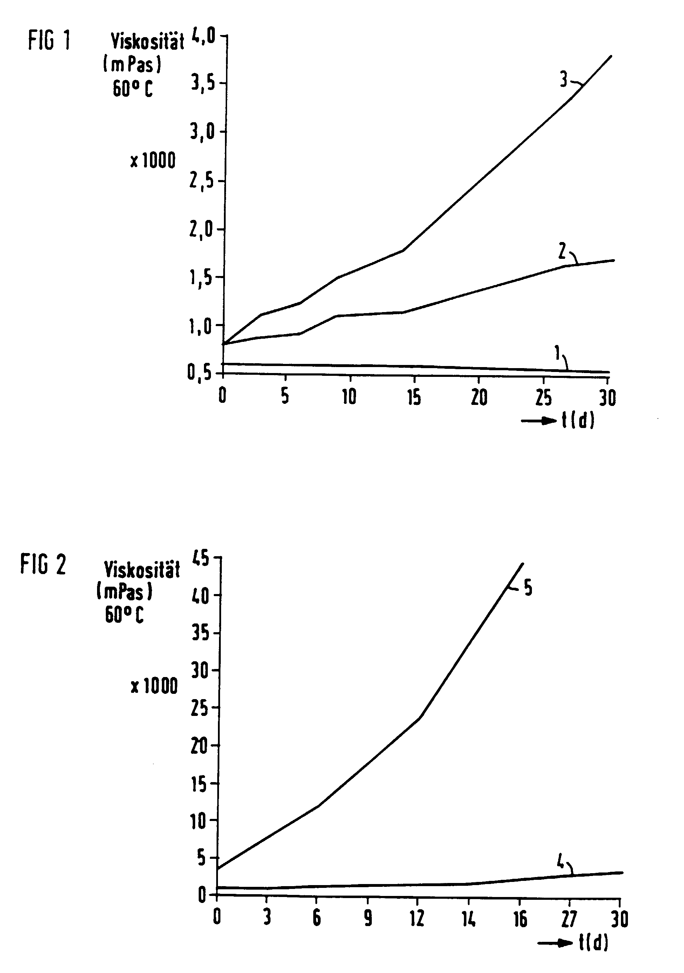

Figur 1 zeigt das Viskositätsverhalten eines dem ersten Ausführungsbeispiel entsprechenden Reaktionsharzsystems unter verschiedenen Bedingungen. Die unterste Kurve 1 zeigt das Viskositätsverhalten einer 3 Prozent Phosphor und 1 Prozent Photoinitiator enthaltenden Reaktionsharzmischung, die nicht UV-aktiviert ist und bei Raumtemperatur gelagert wurde. Die Viskosität des Reaktionsharzsystems bleibt über den Beobachtungszeitraum von 30 Tagen unverändert. Der Viskositätsanstieg des gleichen Reaktionsharzsystems nach UV-Aktivierung und bei Lagerung bei 5°C wird von der Kuve 2 dargestellt. Auch hier zeigt sich nach 30 Tagen eine nur unwesentliche Erhöhung der Viskosität; das Reaktionsharzsystem ist noch gut verarbeitbar.

Die Kurve 3 zeigt das Viskositätsverhalten der aktivierten Mischung während einer Lagerung bei Raumtemperatur. Die Viskosität steigt zwar an, hat jedoch nach 30 Tagen erst einen Wert von ca. 3700 mPa·s erreicht, bei dem das Gießharz noch gut zu verarbeiten ist.

Figur 2 zeigt das Viskositätsverhalten eines Reaktionsharzsystems in Abhängigkeit von zwei unterschiedlichen Phosphorgehalten. Kurve 4 zeigt das Verhalten einer Reaktionsharzmischung mit einem Phosphorgehalt von 3 Prozent, während das durch Kurve 5 belegte Verhalten anhand einer Reaktionsharzmischung bestimmt ist, die 2 Prozent Phosphor enthält. Klar wird, daß ein höherer Phosphorgehalt die Lagerstabilität der UV-aktivierten Reaktionsharzmischung bei Raumtemperatur erhöht. Doch selbst mit dem geringen Phosphoranteil ist eine aktivierte Reaktionsharzmischung noch nach 5 Tagen verarbeitbar. Deutlich verlängert wird die Gebrauchsdauer, wenn die Photoinitiatorkonzentration auf 0,5 Prozent abgesenkt und die Bestrahlungszeit verkürzt werden.

Das erfindungsgemäße Reaktionsharzsystem ist daher bestens zum Vergießen beliebiger Werkstücke, insbesondere von elektronischen Bauelementen geeignet. Die gemäßigten Härtungsbedingungen ermöglichen eine relativ spannungsarme Härtung, während die hohe Lagerstabilität und die niedrige Viskosität die automatisierte Verarbeitung und Applikation der Reaktionsharzsysteme erleichtern.

## Patentansprüche

1. Einkomponentiges Reaktionsharzsystem bestehend aus
A) ein Epoxidharz bzw. eine Epoxidharzmischung
B) ein Photoinitiator für einen kationischen Härtungsprozeß
C) eine Phosphorverbindung der allgemeinen Formel 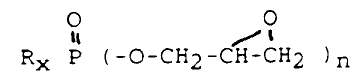 wobei die Reste R unabhängig voneinander für einen Alkyl-, Aryl-, Hydroxyalkyl- oder Alkyloxy-Rest stehen, n = 2 oder 3 und x = (3 - n), und wobei der Bestandteil C in einem Anteil von mehr als 5 Gewichtsprozent im Reaktionsharzsystem enthalten ist.

2. Reaktionsharzsystem nach Anspruch 1,
bei dem der Bestandteil B ausgewählt ist aus Oniumsalzen mit Stickstoff, Phosphor, Sauerstoff, Selen, Jod oder Schwefel als Zentralatom des Kations.

3. Reaktionsharzsystem nach Anspruch 1,
bei dem der Bestandteil B ein Komplexsalz mit einem Übergangsmetall als Kation ist.

4. Reaktionsharzsystem nach einem der Ansprüche 1 bis 3,
das zusätzlich einen Sensibilisator zur Aktivierung eines säurebildenden Initiators enthält.

5. Reaktionsharzsystem nach einem der Ansprüche 1 bis 4,
welches weitere für Gießharze übliche Zusätze enthält, die ausgewählt sind aus Haftvermittlern, Verlaufshilfsmitteln, Farbstoffen, Thixotropierungsmitteln und Füllstoffen.

6. Reaktionsharzsystem nach einem der Ansprüche 1 bis 5
bei dem der allgemeine Rest R des Glycidylesters ein Arylrest ist.

7. Reaktionsharzsystem nach einem der Ansprüche 1 bis 4,
bei dem der Bestandteil C eine Phosphorverbindung mit Hydroxylalkylrest ist.

8. Reaktionsharzsystem nach einem der Ansprüche 1 bis 7,
bei dem die Epoxidkomponente A ausgewählt ist aus den Glycidylethern von Bisphenolen und von Novolaken und aus cycloaliphatischen Epoxiden.

9. Reaktionsharzsystem nach einem der Ansprüche 1 bis 8,
welches einen Phosphoranteil von 1 bis 5 Gewichtsprozent, vorzugsweise von 2 bis 4 Gewichtsprozent aufweist, so daß bei der Härtung flammwidrige Formstoffe entstehen.

10. Verwendung eines Reaktionsharzsystems nach einem der Ansprüche 1 bis 9,
als Gießharz oder für Reaktionsspritzguß, wobei das Reaktionsharzsystem vor dem Vergießen oder der Injektion in die Form mittels UV-Licht aktiviert und nach der Applikation thermisch ausgehärtet wird.

11. Verwendung des Reaktionsharzsystems nach einem der vorangehenden Ansprüche zum Vergießen, Abdecken und Verkleben von elektrischen und elektronischen Bauelementen.

## Claims

1. One-component reactive resin system comprising
A) an epoxy resin or an epoxy resin mixture
B) a photoinitiator for a cationic curing process
C) a phosphorus compound of the general formula 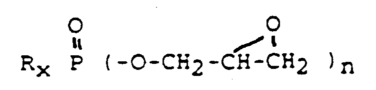 in which the radicals R independently of one another are an alkyl, aryl, hydroxyalkyl or alkyloxy radical, n = 2 or 3 and x = (3 - n), and wherein the reactive resin system comprises constituent C in an amount of more than 5 per cent by weight.

2. Reactive resin system according to Claim 1,
in which constituent B is chosen from onium salts with nitrogen, phosphorus, oxygen, selenium, iodine or sulphur as the central atom of the cation.

3. Reactive resin system according to Claim 1,
in which constituent B is a complex salt with a transition metal as cation.

4. Reactive resin system according to one of Claims 1 to 3,
which additionally comprises a sensitizer for activation of an acid-forming initiator.

5. Reactive resin system according to one of Claims 1 to 4,
which comprises further additives customary for casting resins, selected from adhesion promoters, flow auxiliaries, dyestuffs, thixotropic agents and fillers.

6. Reactive resin system according to one of Claims 1 to 5,
in which the general radical R of the glycidyl ester is an aryl radical.

7. Reactive resin system according to one of Claims 1 to 4,
in which constituent C is a phosphorus compound with a hydroxyl alkyl radical.

8. Reactive resin system according to one of Claims 1 to 7,
in which the epoxy component A is selected from glycidyl ethers of bisphenols and of novolaks and from cycloaliphatic epoxides.

9. Reactive resin system according to one of Claims 1 to 8,
which has a phosphorus content of 1 to 5 per cent by weight, preferably 2 to 4 per cent by weight, so that flame-resistant moulded materials are formed on curing.

10. Use of a reactive resin system according to one of Claims 1 to 9
as a casting resin or for reaction injection moulding, wherein the reactive resin system is activated before the embedding or the injection into the mould by means of UV light and is completely cured by means of heat after the application.

11. Use of the reactive resin system according to one of the preceding claims for embedding, covering and gluing electrical and electronic components.

## Revendications

1. Système de résine composite à un seul composant constitué par
A) une résine époxy, respectivement un mélange de résines époxy,
B) un photoinitiateur pour un procédé de durcissement cationique,
C) un composé de phosphore répondant à la formule générale 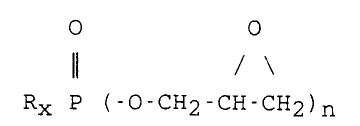 dans laquelle les radicaux R représentent, indépendamment l'un de l'autre, un radical alkyle, un radical aryle, un radical hydroxyalkyle ou un radical alcoxy, n = 2 ou 3 et x = (3 - n), et dans laquelle le constituant C est contenu dans le système de résine composite en une fraction supérieure à 5 pour cent en poids.

2. Système de résine composite selon la revendication 1, dans lequel le constituant B est choisi parmi le groupe comprenant des sels d'onium, un atome d'azote, un atome de phosphore, un atome d'oxygène, un atome de sélénium, un atome d'iode ou un atome de soufre représentant l'atome central du cation.

3. Système de résine composite selon la revendication 1, dans lequel le constituant B est un sel complexe comprenant un métal transitoire à titre de cation.

4. Système de résine composite selon l'une quelconque des revendications 1 à 3, qui contient en outre un sensibilisateur pour l'activation d'un initiateur acidifiant.

5. Système de résine composite selon l'une quelconque des revendications 1 à 4, qui contient d'autres additifs habituels pour des résines de coulée, qui sont choisis parmi le groupe comprenant des adhésifs, des adjuvants de nivellement, des colorants, des agents rendant thixotrope et des matières de charge.

6. Système de résine composite selon l'une quelconque des revendications 1 à 5, dans lequel le radical général R de l'ester glycidylique est un radical aryle.

7. Système de résine composite selon l'une quelconque des revendications 1 à 4, dans lequel le constituant C est un composé de phosphore contenant un radical hydroxyalkyle.

8. Système de résine composite selon l'une quelconque des revendications 1 à 7, dans lequel le composant époxy A est choisi parmi le groupe comprenant les éthers glycidyliques de bisphénols et de novolaques et parmi le groupe comprenant des groupes époxy cycloaliphatiques.

9. Système de résine composite selon l'une quelconque des revendications 1 à 8, qui présente une fraction de phosphore de 1 à 5% en poids, de préférence de 2 à 4% en poids, si bien que l'on obtient, lors du durcissement, des matières moulées ininflammables.

10. Utilisation d'un système de résine composite selon l'une quelconque des revendications 1 à 9, à titre de résine de coulée ou pour le moulage réactif par injection, dans laquelle on active le système de résine composite à la lumière UV avant la coulée ou l'injection dans le moule et on le durcit par voie thermique après l'application.

11. Utilisation du système de résine composite selon l'une quelconque des revendications précédentes pour la coulée, le recouvrement et le collage de composants électriques et électroniques.
